# EUROPEAN PATENT APPLICATION

(11) **EP 4 474 908 A1**
(43) Date of publication of application: **11.12.2024**
(21) Application number: 23177916.6
(22) Date of filing: 07.06.2023
(51) Int. Cl.: G03F 7/00

(54) **FOCUS METROLOGY METHOD AND ASSOCIATED METROLOGY DEVICE**

(71) Applicant: ASML Netherlands B.V., 5500 AH Veldhoven (NL)
(72) Inventor: CALADO, Victor, Emanuel, Veldhoven (NL); VAN LEEST, Adriaan, Johan, Veldhoven (NL); THISSEN, Nick, Franciscus, Wilhelmus, Veldhoven (NL); MATHIJSSEN, Simon, Gijsbert, Josephus, Veldhoven (NL)
(74) Representative: ASML Netherlands B.V.

(57) **Abstract**

Disclosed is a method of determining at least one exposure parameter such as focus and/or dose. The method comprises obtaining production metrology data for a plurality of structures; grouping said production metrology data into a plurality of neighbor groups, each neighbor group describing a different arrangement of said structures; obtaining pre-calibrated sensitivity relationship data for each of said plurality of neighbor groups or different combinations thereof, and inferring said at least one exposure parameter from the production metrology data and pre-calibrated sensitivity relationship data.

## Description

### FIELD OF THE INVENTION

The present invention relates to a target arrangement for metrology of a lithographic process and to a method to measure a parameter of a lithographic process.

### BACKGROUND

A lithographic apparatus is a machine that applies a desired pattern onto a substrate, usually onto a target portion of the substrate. A lithographic apparatus can be used, for example, in the manufacture of integrated circuits (ICs). In that instance, a patterning device, which is alternatively referred to as a mask or a reticle, may be used to generate a circuit pattern to be formed on an individual layer of the IC. This pattern can be transferred onto a target portion (e.g., including part of, one, or several dies) on a substrate (e.g., a silicon wafer). Transfer of the pattern is typically via imaging onto a layer of radiation-sensitive material (resist) provided on the substrate. In general, a single substrate will contain a network of adjacent target portions that are successively patterned. In lithographic processes, it is desirable frequently to make measurements of the structures created, e.g., for process control and verification. Various tools for making such measurements are known, including scanning electron microscopes, which are often used to measure critical dimension (CD), and specialized tools to measure overlay, a measure of the accuracy of alignment of two layers in a device. Overlay may be described in terms of the degree of misalignment between the two layers, for example reference to a measured overlay of 1nm may describe a situation where two layers are misaligned by 1nm.

Recently, various forms of scatterometers have been developed for use in the lithographic field. These devices direct a beam of radiation onto a target and measure one or more properties of the scattered radiation - e.g., intensity at a single angle of reflection as a function of wavelength; intensity at one or more wavelengths as a function of reflected angle; or polarization as a function of reflected angle - to obtain a "spectrum" from which a property of interest of the target can be determined. Determination of the property of interest may be performed by various techniques: e.g., reconstruction of the target by iterative approaches such as rigorous coupled wave analysis or finite element methods; library searches; and principal component analysis.

The targets used by conventional scatterometers are relatively large, e.g., 40µm by 40µm, gratings and the measurement beam generates a spot that is smaller than the grating (i.e., the grating is underfilled). This simplifies mathematical reconstruction of the target as it can be regarded as infinite. However, in order to reduce the size of the targets, e.g., to 10µm by 10µm or less, e.g., so they can be positioned in amongst product features, rather than in the scribe lane, metrology has been proposed in which the grating is made smaller than the measurement spot (i.e., the grating is overfilled). Typically such targets are measured using dark field scatterometry in which the zeroth order of diffraction (corresponding to a specular reflection) is blocked, and only higher orders processed. Examples of dark field metrology can be found in international patent applications WO 2009/078708 and WO 2009/106279 which documents are hereby incorporated by reference in their entirety. Further developments of the technique have been described in patent publications US20110027704A, US20110043791A and US20120242970A. Modifications of the apparatus to improve throughput are described in US2010201963A1 and US2011102753A1. The contents of all these applications are also incorporated herein by reference. Diffraction-based overlay using dark-field detection of the diffraction orders enables overlay measurements on smaller targets. These targets can be smaller than the illumination spot and may be surrounded by product structures on a wafer (wafer and substrate may be used synonymously throughout this disclosure). Targets can comprise multiple gratings which can be measured in one image.

One important parameter of a lithographic process which requires monitoring is focus. There is a desire to integrate an ever-increasing number of electronic components in an IC. To realize this, it is necessary to decrease the size of the components and therefore to increase the resolution of the projection system, so that increasingly smaller details, or line widths, can be projected on a target portion of the substrate. As the critical dimension (CD) in lithography shrinks, consistency of focus, both across a substrate and between substrates, becomes increasingly important. CD is the dimension of a feature or features (such as the gate width of a transistor) for which variations will cause undesirable variation in physical properties of the feature.

Traditionally, optimal settings were determined by "send-ahead wafers" i.e. substrates that are exposed, developed and measured in advance of a production run. In the send-ahead wafers, test structures were exposed in a so-called focus-energy matrix (FEM) and the best focus and energy (exposure dose) settings were determined from examination of those test structures. More recently, focus metrology targets are included in the production designs, to allow continuous monitoring of focus performance. These metrology targets should permit rapid measurements of focus, to allow fast performance measurement in high-volume manufacturing. Ideally, the metrology targets should be small enough that they can be placed among the product features without undue loss of space.

Asymmetry in a grating structure can be measured effectively using high-speed inspection apparatus such as a scatterometer, working at visible radiation wavelengths. Known focus measuring techniques exploit the fact that focus-sensitive asymmetry can be introduced into structures printed in a resist layer by special design of the patterns on a patterning device that defines the target structure. This may be achieved by defining the structures on the reticle with sub-resolution structures which print with a focus dependent sensitivity manifesting as said focus-sensitive asymmetry. For EUV lithography, where printing is performed using radiation of a wavelength less than 20 nm, for example 13.5 nm, the creation of sub-resolution features becomes more difficult. For EUV lithography, resist thickness, and therefore the thickness of target structures, is smaller. This weakens the diffraction efficiency, and hence the signal strength, available for focus metrology.

For these reasons, it is desirable to develop new techniques for the measurement of focus performance in lithographic processes, particularly in EUV lithography, but also for projection-based lithography in general.

### SUMMARY OF THE INVENTION

It would be desirable to be able to perform metrology of a lithographic process with increased accuracy.

The invention in a first aspect provides a method of determining at least one exposure parameter describing an exposure setting of a lithographic exposure process in which a plurality of structures were exposed on a product substrate; the method comprising: obtaining production metrology data describing respective product parameter values relating to at least one product parameter of each said plurality of structures; grouping said production metrology data into a plurality of neighbor groups, each neighbor group describing a different arrangement of said structures; obtaining pre-calibrated sensitivity relationship data for each of said plurality of neighbor groups or different combinations thereof, the sensitivity relationship data relating the product parameter, per neighbor group or different combinations thereof, to said at least one exposure parameter; and inferring said at least one exposure parameter from the production metrology data and pre-calibrated sensitivity relationship data.

Further features and advantages of the invention, as well as the structure and operation of various embodiments of the invention, are described in detail below with reference to the accompanying drawings. It is noted that the invention is not limited to the specific embodiments described herein. Such embodiments are presented herein for illustrative purposes only. Additional embodiments will be apparent to persons skilled in the relevant art(s) based on the teachings contained herein.

### BRIEF DESCRIPTION OF THE DRAWINGS

Embodiments of the invention will now be described, by way of example only, with reference to the accompanying drawings in which:
Figure 1 depicts a lithographic apparatus according to an embodiment of the invention;
Figure 2 depicts a lithographic cell or cluster according to an embodiment of the invention;
Figure 3 is a flowchart describing a method according to a first embodiment;
Figure 4 schematically illustrates a number of steps of the method described by Figure 3;
Figure 5(a) and Figure 5(b) schematically illustrate different methods for grouping the production metrology data into different groups depending on its neighboring structures; and
Figure 6 is a flowchart describing a method according to a second embodiment.

### DETAILED DESCRIPTION OF EXEMPLARY EMBODIMENTS

Before describing embodiments of the invention in detail, it is instructive to present an example environment in which embodiments of the present invention may be implemented.

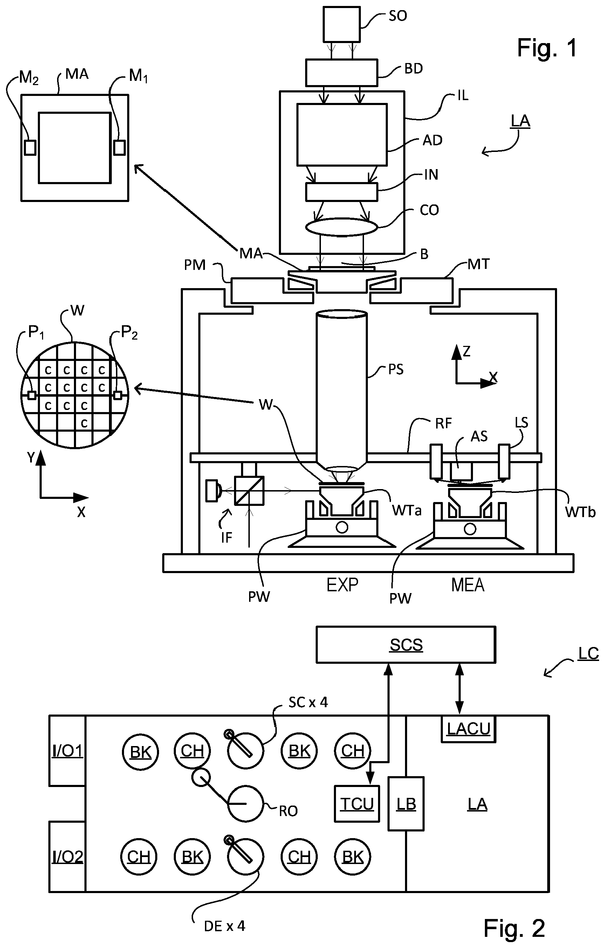

Figure 1 schematically depicts a lithographic apparatus LA. The apparatus includes an illumination optical system (illuminator) IL configured to condition a radiation beam B (e.g., UV radiation or DUV radiation), a patterning device support or support structure (e.g., a mask table) MT constructed to support a patterning device (e.g., a mask) MA and connected to a first positioner PM configured to accurately position the patterning device in accordance with certain parameters; a substrate table (e.g., a wafer table) WT constructed to hold a substrate (e.g., a resist coated wafer) W and connected to a second positioner PW configured to accurately position the substrate in accordance with certain parameters; and a projection optical system (e.g., a refractive projection lens system) PS configured to project a pattern imparted to the radiation beam B by patterning device MA onto a target portion C (e.g., including one or more dies) of the substrate W.

The illumination optical system may include various types of optical or non-optical components, such as refractive, reflective, magnetic, electromagnetic, electrostatic or other types of components, or any combination thereof, for directing, shaping, or controlling radiation.

The patterning device support holds the patterning device in a manner that depends on the orientation of the patterning device, the design of the lithographic apparatus, and other conditions, such as for example whether or not the patterning device is held in a vacuum environment. The patterning device support can use mechanical, vacuum, electrostatic or other clamping techniques to hold the patterning device. The patterning device support may be a frame or a table, for example, which may be fixed or movable as required. The patterning device support may ensure that the patterning device is at a desired position, for example with respect to the projection system. Any use of the terms "reticle" or "mask" herein may be considered synonymous with the more general term "patterning device."

The term "patterning device" used herein should be broadly interpreted as referring to any device that can be used to impart a radiation beam with a pattern in its cross-section such as to create a pattern in a target portion of the substrate. It should be noted that the pattern imparted to the radiation beam may not exactly correspond to the desired pattern in the target portion of the substrate, for example if the pattern includes phase-shifting features or so called assist features. Generally, the pattern imparted to the radiation beam will correspond to a particular functional layer in a device being created in the target portion, such as an integrated circuit.

The patterning device may be transmissive or reflective. Examples of patterning devices include masks, programmable mirror arrays, and programmable LCD panels. Masks are well known in lithography, and include mask types such as binary, alternating phase-shift, and attenuated phase-shift, as well as various hybrid mask types. An example of a programmable mirror array employs a matrix arrangement of small mirrors, each of which can be individually tilted so as to reflect an incoming radiation beam in different directions. The tilted mirrors impart a pattern in a radiation beam, which is reflected by the mirror matrix.

As here depicted, the apparatus is of a transmissive type (e.g., employing a transmissive mask). Alternatively, the apparatus may be of a reflective type (e.g., employing a programmable mirror array of a type as referred to above, or employing a reflective mask).

The lithographic apparatus may also be of a type wherein at least a portion of the substrate may be covered by a liquid having a relatively high refractive index, e.g., water, so as to fill a space between the projection system and the substrate. An immersion liquid may also be applied to other spaces in the lithographic apparatus, for example, between the mask and the projection system. Immersion techniques are well known in the art for increasing the numerical aperture of projection systems. The term "immersion" as used herein does not mean that a structure, such as a substrate, must be submerged in liquid, but rather only means that liquid is located between the projection system and the substrate during exposure.

Referring to Figure 1, the illuminator IL receives a radiation beam from a radiation source SO. The source and the lithographic apparatus may be separate entities, for example when the source is an excimer laser. In such cases, the source is not considered to form part of the lithographic apparatus and the radiation beam is passed from the source SO to the illuminator IL with the aid of a beam delivery system BD including, for example, suitable directing mirrors and/or a beam expander. In other cases the source may be an integral part of the lithographic apparatus, for example when the source is a mercury lamp. The source SO and the illuminator IL, together with the beam delivery system BD if required, may be referred to as a radiation system.

The illuminator IL may include an adjuster AD for adjusting the angular intensity-distribution of the radiation beam. Generally, at least the outer and/or inner radial extent (commonly referred to as σ-outer and σ-inner, respectively) of the intensity-distribution in a pupil plane of the illuminator can be adjusted. In addition, the illuminator IL may include various other components, such as an integrator IN and a condenser CO. The illuminator may be used to condition the radiation beam, to have a desired uniformity and intensity-distribution in its cross section.

The radiation beam B is incident on the patterning device (e.g., mask) MA, which is held on the patterning device support (e.g., mask table MT), and is patterned by the patterning device. Having traversed the patterning device (e.g., mask) MA, the radiation beam B passes through the projection optical system PS, which focuses the beam onto a target portion C of the substrate W, thereby projecting an image of the pattern on the target portion C. With the aid of the second positioner PW and position sensor IF (e.g., an interferometric device, linear encoder, 2-D encoder or capacitive sensor), the substrate table WT can be moved accurately, e.g., so as to position different target portions C in the path of the radiation beam B. Similarly, the first positioner PM and another position sensor (which is not explicitly depicted in Figure 1) can be used to accurately position the patterning device (e.g., mask) MA with respect to the path of the radiation beam B, e.g., after mechanical retrieval from a mask library, or during a scan.

Patterning device (e.g., mask) MA and substrate W may be aligned using mask alignment marks M1, M2 and substrate alignment marks P1, P2. Although the substrate alignment marks as illustrated occupy dedicated target portions, they may be located in spaces between target portions (these are known as scribe-lane alignment marks). Similarly, in situations in which more than one die is provided on the patterning device (e.g., mask) MA, the mask alignment marks may be located between the dies. Small alignment markers may also be included within dies, in amongst the device features, in which case it is desirable that the markers be as small as possible and not require any different imaging or process conditions than adjacent features. The alignment system, which detects the alignment markers is described further below.

Lithographic apparatus LA in this example is of a so-called dual stage type which has two substrate tables WTa, WTb and two stations - an exposure station and a measurement station - between which the substrate tables can be exchanged. While one substrate on one substrate table is being exposed at the exposure station, another substrate can be loaded onto the other substrate table at the measurement station and various preparatory steps carried out. The preparatory steps may include mapping the surface control of the substrate using a level sensor LS and measuring the position of alignment markers on the substrate using an alignment sensor AS. This enables a substantial increase in the throughput of the apparatus.

The depicted apparatus can be used in a variety of modes, including for example a step mode or a scan mode. The construction and operation of lithographic apparatus is well known to those skilled in the art and need not be described further for an understanding of the present invention.

As shown in Figure 2, the lithographic apparatus LA forms part of a lithographic system, referred to as a lithographic cell LC or a lithocell or cluster. The lithographic cell LC may also include apparatus to perform pre- and post-exposure processes on a substrate. Conventionally these include spin coaters SC to deposit resist layers, developers DE to develop exposed resist, chill plates CH and bake plates BK. A substrate handler, or robot, RO picks up substrates from input/output ports I/O1, I/O2, moves them between the different process apparatus and delivers then to the loading bay LB of the lithographic apparatus. These devices, which are often collectively referred to as the track, are under the control of a track control unit TCU which is itself controlled by the supervisory control system SCS, which also controls the lithographic apparatus via lithography control unit LACU. Thus, the different apparatus can be operated to maximize throughput and processing efficiency.

In order that the substrates that are exposed by the lithographic apparatus are exposed correctly and consistently, it is desirable to inspect exposed substrates to measure properties such as overlay errors between subsequent layers, line thicknesses, critical dimensions (CD), etc. Accordingly a manufacturing facility in which lithocell LC is located also includes metrology system MET which receives some or all of the substrates W that have been processed in the lithocell. Metrology results are provided directly or indirectly to the supervisory control system SCS. If errors are detected, adjustments may be made to exposures of subsequent substrates, especially if the inspection can be done soon and fast enough that other substrates of the same batch are still to be exposed. Also, already exposed substrates may be stripped and reworked to improve yield, or discarded, thereby avoiding performing further processing on substrates that are known to be faulty. In a case where only some target portions of a substrate are faulty, further exposures can be performed only on those target portions which are good.

Within metrology system MET, an inspection apparatus is used to determine the properties of the substrates, and in particular, how the properties of different substrates or different layers of the same substrate vary from layer to layer. The inspection apparatus may be integrated into the lithographic apparatus LA or the lithocell LC or may be a stand-alone device. To enable most rapid measurements, it is desirable that the inspection apparatus measure properties in the exposed resist layer immediately after the exposure. However, the latent image in the resist has a very low contrast - there is only a very small difference in refractive index between the parts of the resist which have been exposed to radiation and those which have not - and not all inspection apparatuses have sufficient sensitivity to make useful measurements of the latent image. Therefore measurements may be taken after the post-exposure bake step (PEB) which is customarily the first step carried out on exposed substrates and increases the contrast between exposed and unexposed parts of the resist. At this stage, the image in the resist may be referred to as semi-latent. It is also possible to make measurements of the developed resist image - at which point either the exposed or unexposed parts of the resist have been removed - or after a pattern transfer step such as etching. The latter possibility limits the possibilities for rework of faulty substrates but may still provide useful information.

In the following disclosure, techniques will be illustrated for measuring focus performance of a lithographic process. These techniques may be applied in particular in EUV lithography, where resist thickness is small. More specifically, the proposed method will comprise a method of measuring one or more exposure parameters, where the one or more exposure parameters may comprise focus and/or dose. Focus and dose in this context may relate to respectively a focus setting and a dose setting of a lithographic exposure process on which a measured structure was exposed.

In the context of lithographic apparatuses working in the DUV wavelength range, targets for diffraction-based focus (DBF) measurements have been designed and used successfully. A known type of DBF target is produced by including sub-resolution features in a grating pattern on the reticle. These features have dimensions below the imaging resolution of the lithographic apparatus, alongside more solid features. Consequently, they do not print as individual features in the resist layer on the substrate, but they influence the printing of the solid features, in a manner that is sensitive to focus error. Specifically, the presence of these features creates an asymmetric resist profile for each line in the grating within the DBF metrology target, with the degree of asymmetry being dependent upon focus. Consequently a metrology tool such as a scatterometer can measure the degree of asymmetry from a target formed on the substrate, and translate this into the scanner focus.

Unfortunately, the known DBF metrology target designs are not suitable for use in all situations. In EUV lithography, resist film thicknesses are significantly lower than those used in DUV immersion lithography, leading to low diffraction efficiency and difficulty extracting accurate asymmetry information from diffracted radiation in the scatterometer. In addition, since the resolution of the imaging system is inherently higher in EUV lithography, features having dimensions below the printing resolution of DUV immersion lithography become "solid" features printable by EUV lithography. To provide analogous sub-resolution features on an EUV reticle is rather impractical, and/or may violate semiconductor manufacturer's "design rules". Such rules are generally established as a means to restrict the feature designs to ensure the printed features conform to their process requirements. In any case, working outside the design rules makes it difficult to simulate the performance of the process on the DBF targets, so that the optimum target design and the calibration of focus measurements becomes a matter of trial-and-error. The desire to conform to design rules applies to DBF targets in DUV lithography, not only EUV lithography.

As such, an alternative metrology method for measuring an exposure parameter (e.g., focus and/or dose) which is compatible with thin resists and EUV lithography is desirable. However, the methods disclosed herein are not limited to EUV lithography and can be used to measure the focus parameter in DUV lithography or in lithography generally.

The proposed method comprises obtaining production metrology data describing at least one product parameter of a plurality of structures such as a plurality of contact holes or vias on a wafer, e.g., using a scanning electron microscope (SEM) or any other suitable metrology device. Contact holes will be assumed throughout this disclosure, although any suitable structure may be used. The contact holes are grouped into plurality of neighbor groups, each neighbor group describing, for each structure, an arrangement of neighboring or adjacent structures (e.g., contact holes). Adjacent in this context may mean within a set distance. Structures may be considered adjacent if they are within a distance within which optical proximity effects occur. e.g., the set distance may be defined as being within 10 times the exposure wavelength (wavelength of the exposure radiation), within 7 times the exposure wavelength or within 5 times the exposure wavelength. For example, in EUV metrology, the distances in absolute terms may be smaller than (about) 65nm, smaller than 95nm or smaller than 130nm.

Pre-calibrated sensitivity relationships for each of said plurality of neighbor groups are used to infer one or more exposure parameters (e.g., focus and/or dose) from the production metrology data.

In much of the description below, the production metrology data comprises product displacement data describing a respective displacement (e.g., a placement error with respect to a desired position) of the plurality of structures. However, this is only an example of a product parameter described by the production metrology data. Other suitable product parameters may include CD (or any other dimensional parameter), any placement parameter, any shape parameter (e.g., ellipticity) or any roughness values (e.g., contact edge roughness CER, line edge roughness LER or line width roughness LWR). These parameters of interest can also be combined.

The pre-calibrated sensitivity relationships may be calibrated in an initial calibration step based on measurement of a calibration wafer (e.g., a focus-dose matrix or FEM wafer) where contact holes (or other calibration structures) are exposed at multiple different focus and dose settings. The calibration wafer can then be measured for contact hole displacement, the resultant calibration metrology data grouped into a neighbor group and a model determined which relates the calibration metrology data to one or more exposure settings.

Product parameters such as, for example, the CD, placement, shape or roughness of a structure such as a contact hole are sensitive to dose and focus. The inventors have appreciated that this sensitivity depends on the surrounding layout of the contact hole. For example, a contact hole neighborhood or neighbor group may be determined for each contact hole, the contact hole neighborhood describing the presence and location of adjacent contact holes (e.g., adjacent in either the x direction or y direction and/or in diagonal directions). As such, each contact hole neighborhood may describe whether there are contact holes immediately adjacent orthogonally- i.e., immediately above (or immediately north), immediately below (or immediately south), immediately left (or immediately west) or immediately right (or immediately east) on the wafer plane (e.g., in the X/Y plane). Alternatively, or in addition, each neighborhood may describe whether there are contact holes immediately diagonally, e.g., immediately north-west, immediately north-east, immediately south-east or immediately south-west. As such, an arrangement of adjacent structures may describe, for each structure, whether each of a plurality of neighborhood regions within a neighborhood area defined around said structure comprises at least one adjacent structure.

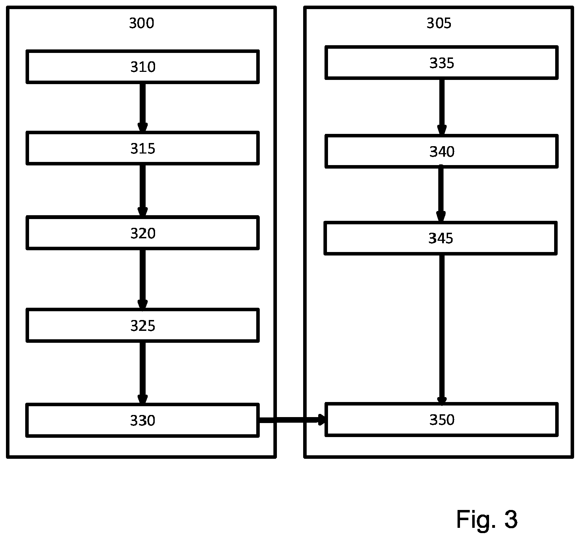

Figure 3 is a flowchart of a proposed method including a calibration phase 300 and a production phase 305. In the calibration phase 300, an FEM wafer or calibration wafer may be exposed 310 and a product parameter (such as the contact hole displacement) is measured 315 to obtain calibration metrology data (e.g., calibration displacement data). The product parameter will be assumed to be displacement in this example, although any one or more of the previously mentioned parameters may be equally applicable. The calibration metrology data may comprise calibration x-displacement data relating to displacement in a first direction (or x direction) of the wafer plane and calibration y-displacement data relating to displacement in a second direction (or y direction) of the wafer plane, perpendicular to the first direction.

The calibration metrology data (relating to all of the measured contact holes or a subset thereof) may be grouped 320 into neighbor groups describing the neighborhood of each contact hole. Representative calibration metrology data may be determined from the calibration metrology data (e.g., separately for each of the x-displacement data and y-displacement data). This representative calibration metrology data may comprise a representative calibration displacement value in each of the first direction and second direction for each dose-focus setting, per neighbor group. The representative calibration value may be an average value for the group; e.g., such as a mean or variance (or a combination of both) of the displacement values within each group. As such, in an embodiment this step may yield a mean displacement along the x-direction and y-direction, stratified per neighbor group, for each dose-focus setting used to expose the calibration wafer.

At step 325, the variation in displacement with exposure setting (focus and dose) is modeled. This may comprise, for example, modeling the relationships between the representative calibration metrology data and the set focus/dose values for each neighbor group. For example, this may comprise constructing a matrix of said representative calibration values comprising (*N_{dose-focus}*)×-(2∗*N_{group}*) elements, where *N_{dose-focus}* is the number of exposure settings or dose-focus settings used to expose the FEM wafer and *N_{group}* is the number of neighborhood groups (the factor of 2 represents the two displacement directions, x-displacement and y-displacement, assuming two displacement directions are considered separately). A suitable model such as a linear regression model or machine learning model may be used to determine 330 sensitivity data (e.g., models, e.g., in the form of model coefficients) comprising the 2∗*N_{group}* sensitivities or models for each neighbor group. The number of dose-focus settings used on the calibration or FEM wafer may number more than 50, more than 70, more than 100 or more than 110, for example.

The modeling may comprise, for each neighbor group, learning the relationships which are able to predict the (known) dose and focus settings using the representative calibration metrology data per group. By way of a specific example, the training may additionally comprise validating the learning e.g., using train-test methods. For example, this may comprise cross-validation on a (e.g., 80%-20%) train-test method.

In the production phase 305, a product wafer is exposed 335 and production metrology data (e.g., product displacement data describing displacement of contact holes) measured 340 from a production wafer. This production metrology data may be grouped 345 into neighbor groups (e.g., per direction), e.g., in the same manner as performed for step 320 but on the production metrology data. The sensitivity data determined at step 330, which describes the relationship between displacement and focus/dose, can be used to infer 350 on-product focus and/or dose based on the production metrology data. For example, representative production metrology data may be determined comprising a representative product displacement value (e.g., for each direction) per neighbor group. For example, the representative product displacement value may comprise an average (e.g., mean) displacement in each respective direction per neighbor group. The representative product displacement value and the respective calibrated relationship for each of the neighbor groups (or at least a subset thereof) can then be used to infer the focus and/or dose (e.g., per exposure field of the production wafer to determine a focus map and/or dose map describing focus and/or dose over the wafer).

The inferring step 350 may comprise inferring focus and/or dose from said representative production metrology data and said pre-calibrated sensitivity relationship data relating to each said neighbor group simultaneously, e.g., constructing a matrix of the representative product displacement values comprising 2∗*N_{group}* elements and a corresponding number of pre-calibrated sensitivity relationships.

The calibration metrology data and/or production metrology data (e.g., displacement data) may be measured, for example, using a scanning electron microscope (SEM) or transmission electron microscope or any other tool with sufficient resolution to measure contact hole parameters such as displacement. For a typical example product structure, each field of view (FOV) of the SEM may comprise on the order of thousands of contact holes. For example, each FOV may comprise over 2000, over 3000 or over 4000 contact holes. While not all of these contact holes are necessarily grouped and used to determine focus (e.g., not all contact holes necessarily fit into the neighbor groups for which the relationships/sensitivities have been calibrated), it may be that about half or more may be grouped and used in the method disclosed herein. The number of FOVs in an exposure field may number more than 10, more than 20 or more than 30 for example. This may result in grouped contact holes per exposure field to number tens of thousands (e.g., more than 50 thousand).

As an alternative to using product layout contact holes (functional product structures), dedicated targets or proxy structures may be used for the calibration and/or production stages. These dedicated targets may be optimized for dose/focus sensitivity and comprising the desired contact hole groups. Such concepts will be expanded upon later.

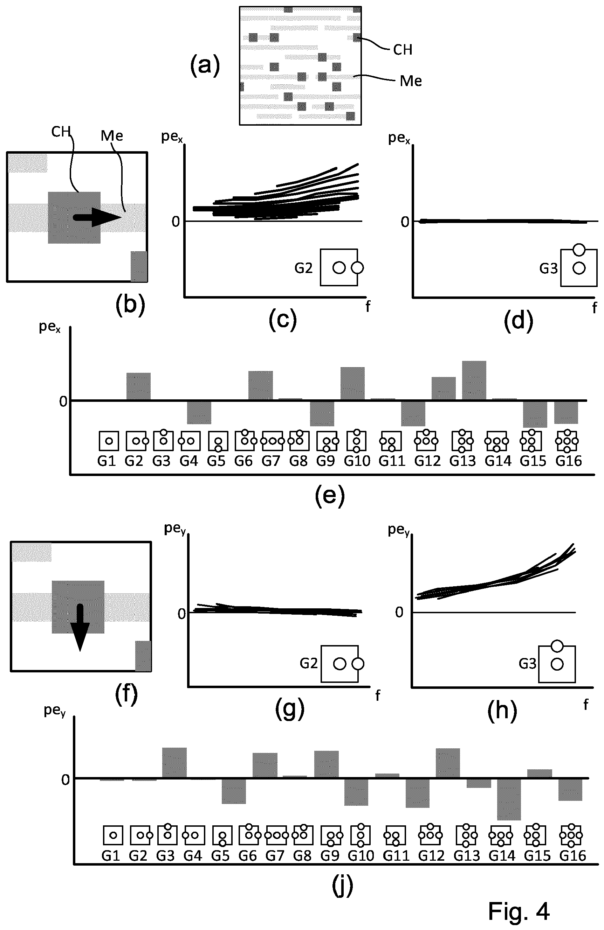

Figure 4 illustrates schematically some of the steps of the proposed method. A product layout (Figure 4(a)) comprises for example contact holes CH and metal connections Me. Placement error or displacement in the x direction (Figure 4(b)) may be measured for each contact hole. The contact holes may be grouped into neighbor groups G1-G16 (Figure 4(e)) i.e., according to the neighboring structures. Though these 16 groups are shown, the number of groups and their arrangements may differ from these examples (e.g., not all of these groups need be used).

As depicted, this may comprise grouping each contact hole according to its neighborhood of adjacent contact holes (e.g., in the x and y directions). Figure 4(e) also shows the representative or mean x-displacement peₓ for each of these groups. Figures 4(c) and 4(d) comprise sensitivity plots, respectively for neighbor group G2 and G3, of the representative or mean x-displacement peₓ with focus f for a plurality of different dose settings (each line comprising a plot for a respective different dose setting). Such plots may be determined for all the other groups. It should be noted that Figure 4(d) shows the same number of plots as Figure 4(c), but the x-displacement for Group G3 is largely invariant to focus and dose variation; this is also apparent from Figure 4(e). Figures 4(f) to 4(j) are equivalent respectively to Figures 4(b) to 4(e), but for y-displacement. Each of these sensitivity plots or sensitivity relationships, once determined/calibrated, may be used to infer an exposure parameter from similarly grouped metrology data, using the respective corresponding relationship for the metrology data of each group.

In the depicted example, only orthogonal groups are shown, where each structure is grouped according to the presence or not of neighbors in each orthogonal direction. In such an example, it may be that each neighbor of a structure of interest can be assigned to one of four positions in relation to the structure of interest. Note that in such a four-position example, the groups may be diagonal groups rather than orthogonal groups.

In another embodiment, each neighbor of a structure of interest can be assigned to one of eight positions in relation to the structure of interest and, as such, each structure of interest may be assigned to a respective orthogonal group and a diagonal group. In such a method, sensitivity relationships may be calibrated for each combination of an orthogonal group and a diagonal group.

The methods above describe a grouping step for grouping the production metrology data into neighbor groups. To achieve this, an example classification method is described. This proposed classification method is based on taxonomy which enables identifying similar patterns in logic and is key for dedicated per-class optimization.

The proposed classification method may comprise for example the following two main stages:
- Stage 1: selecting neighbors of a given feature (e.g., a contact hole) for classification.
- Stage 2: classifying the neighbors selected in stage 1.

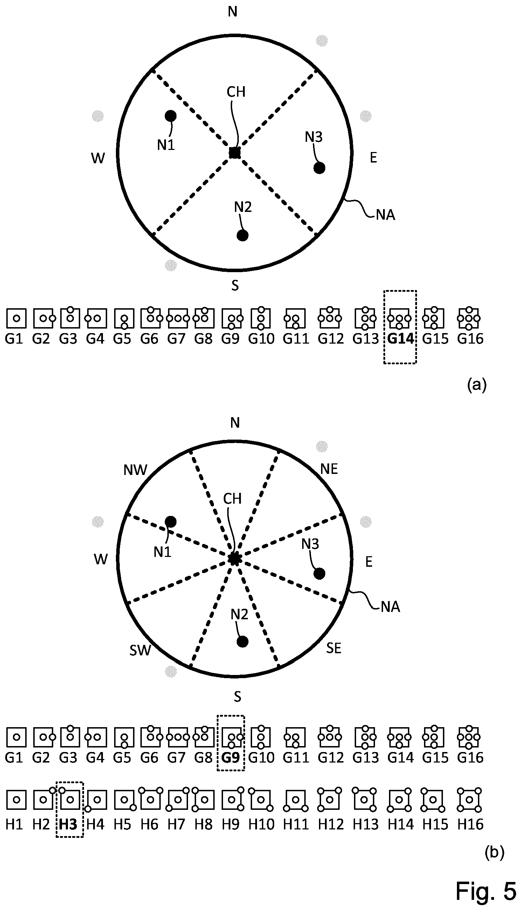

With reference to Figure 5, in an embodiment, stage 1 of the proposed method may comprise the following five steps:
- Step 1: perform a per-structure search within a predefined range. The predefined range may be defined, for example, by a neighborhood area (e.g., a circular area). The circular area may have a certain radius (e.g., a radius of between 50nm and 200nm, between 50nm and 150nm or approximately 100nm) around the structure. The search may be based on, for example, a suitable nearest neighbor algorithm such as e.g., the KD tree algorithm.
- Step 2: compute the distances and angles between the structure and its neighbors.
- Step 3: divide the neighborhood area/predefined range into a number of neighborhood regions or segments. For example, the circular are may be divided into quadrants as illustrated in Figure 5 or into octants as illustrated in Figure 5(b).
- Step 4: associate each neighbor with a segment (e.g., quadrant or octant) within which the neighbor is located.
- Step 5: select the neighbors according to one or more predefined criteria for classification. The selection criteria may include: 1) one neighbor per segment may be used for subsequent classification; 2) if two or more neighbors are in the same segment, the one having the shortest distance to the structure may be used for subsequent classification.

In an embodiment, stage 2 of the proposed method may comprise classifying the neighbors according to the outcome of mapping. In Figure 5(a), which is similar to the grouping method illustrated in Figure 4, the neighborhood area NA of a contact hole CH is divided into four quadrants, a "north" quadrant N, a "south" quadrant S, an "east" quadrant E, and a "west" quadrant W. The neighborhood defined by neighboring structures N1, N2, N3 can be mapped to a particular group G1-G16 depending on the presence or not of one (or more) neighboring structures N1, N2, N3 in each quadrant. In the specific example shown, there are neighboring structures in the "south" quadrant S, "east" quadrant E, and "west" quadrant W which means the neighborhood of this contact hole CH maps to group G14. Note that such a "quadrant" embodiment may have the quadrants rotated through 45 degrees from that shown, in which case the mapping may be to a corresponding diagonal group (e.g., such as labelled H1-H16 in Figure 5(b)) rather than an orthogonal group.

In Figure 5(b), the neighborhood area NA of a contact hole CH is divided into eight octants, a "north" octant N, a "south" octant S, an "east" octant E, a "west" octant W, a "northeast" octant NE, a "northwest" octant NW, a "southeast" octant SE and a "southwest" octant SW. In such an embodiment, the eight octants may be divided into two sets: an orthogonal set (N, E, S, W) and a diagonal set (NE, NW, SE, SW). The orthogonal set may be assessed for the presence of neighboring structures in the orthogonal octants and mapped accordingly to a corresponding orthogonal group G1-G16. Separately, the diagonal set may be assessed for the presence of neighboring structures in the diagonal octants and mapped accordingly to a corresponding diagonal group H1-H16. In this way, the neighborhood of contact hole CH may be described by a combination of orthogonal group and diagonal group, specifically in this example groups G9 and H3. The calibrating and using of sensitivity relationship data in the methods disclosed herein may therefore comprise calibrating and using sensitivity relationships for each such combination.

This taxonomy based classification method may be implemented before the GDS alignment at polygon level. As such, the classification content can be accessible for both metrology and inspection, e.g., by using a SEM or optical-based system. The taxonomy based classification method enables contour stacking and discriminated process windows for logic. The taxonomy based classification method allows easy interpretation of random logic via data.

In many of the above embodiments, it is proposed, in the production phase, to perform SEM (e.g., e-beam) measurements directly on functional product structures to obtain the production metrology data. However, in practice this can be undesirable as SEM metrology may deteriorate the photoresist and therefore damage these structures.

To address this, it is proposed in an embodiment to measure proxy structures, during the production phase, instead of functional product structures, to obtain production proxy metrology data. Such proxy structures may be located close to the functional product structures. For example, a proxy structure may comprise a dedicated target or any other (e.g., sacrificial or non-functional) structure which is representative of (e.g., has similar imaging behavior to) the product layout of interest.

The inferring step in such an embodiment may use first pre-calibrated sensitivity relationship data and mapping data to infer the exposure parameter(s) from the production metrology data. The first pre-calibrated sensitivity relationship data may describe the relationship between the product parameter relating to (e.g., measured from) proxy structures to the at least one exposure parameter, and the mapping data may describe a relationship or offset which maps between the first pre-calibrated sensitivity relationship data and second pre-calibrated sensitivity relationship data, the latter describing the relationship between the product parameter relating to and/or measured from (e.g., functional) product structure to the at least one exposure parameter.

As such, the calibration phase may comprise separately determining sensitivity relationships (i.e., respectively first pre-calibrated sensitivity relationship data and second pre-calibrated sensitivity relationship data) for both calibration proxy metrology data (measured from calibration proxy structures on one or more calibration wafers) and calibration product metrology data (measured from calibration product structures on one or more calibration wafers), and then determining a mapping between these respective sensitivity relationships.

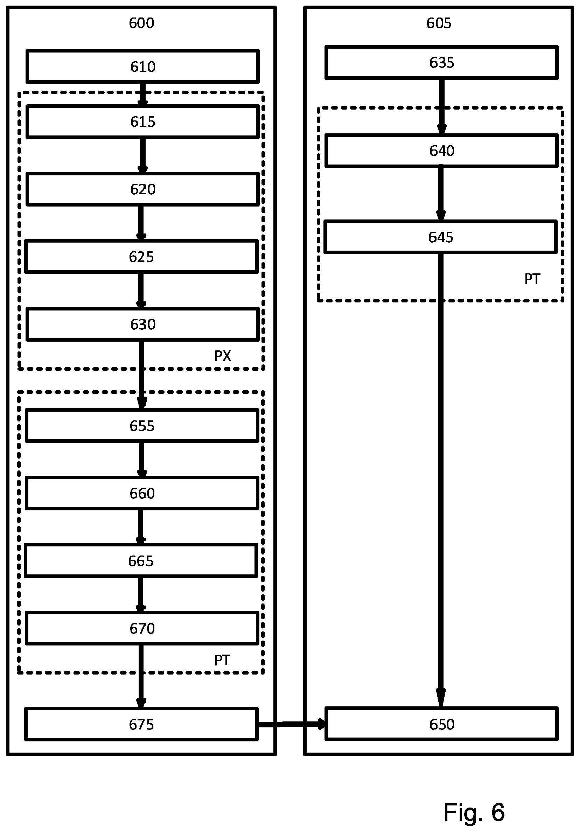

Figure 6 is a flowchart describing such an embodiment. As before, there is a calibration phase 600 and production phase 605. At step 610, an FEM wafer or calibration wafer may be exposed with both calibration product structures (e.g., the same as functional product structures or very similar) and calibration proxy structures (e.g., representative targets, which optionally may be optimized for metrology, e.g., for sensitivity to the exposure parameter(s) of interest).

Steps 615 to 630 are the same as equivalent steps 315 to 330, but performed specifically on the calibration proxy structures PX. Specifically, a product parameter (such as contact hole displacement) is measured 615 from the calibration proxy structures PX to obtain the calibration proxy metrology data. As before, the calibration proxy metrology data may be grouped 620 into neighbor groups and a modeling step 625 is performed on the grouped data, and may otherwise be the same as step 325. Step 630 may yield the first pre-calibrated sensitivity relationship data.

Steps 655 to 670 mirror steps 615 to 630, but are performed on the calibration product structures PT. As such, these steps will yield calibration product metrology data (step 655) and the second pre-calibrated sensitivity relationship data (step 670). Step 675 determines mapping data which describes a mapping (e.g., a linear mapping or otherwise) between the second pre-calibrated sensitivity relationship data to the first pre-calibrated sensitivity relationship data. This mapping may be stored as mapping coefficient and/or intercept/offset data. Of course, there is no significance in the order of steps 615-630 in relation to steps 655-670. Also, it can be appreciated that the metrology steps 615, 655 may be performed before the processing steps 620, 625, 630, 660, 665, 670. As such, the specific order shown is not essential and the steps may be performed in any order except where logic dictates otherwise.

In the production phase 605, product substrates are exposed 635 and production proxy structures (e.g., targets) are measured 640 to obtain production proxy metrology data. The production proxy metrology data is grouped 645 using the methods described. At step 650, the sensitivities determined at step 630 (i.e., the first pre-calibrated sensitivity relationship data) and the mapping data determined at step 675 is used to infer the exposure parameter(s) from the grouped production proxy metrology data. The (e.g., dose and focus) mapping data (e.g., intercepts or offsets) account for differences in best energy and best focus between the production structures and proxy structures and/or for differences in sensitivity between these structures.

Since the proxy structures comprise sacrificial and/or non-functional structures, the structures may be optimized for increased sensitivity to focus.

In an embodiment, the determined on-product exposure parameter(s) may be fed back in a control loop to control the exposure process; e.g., fed back to the scanner for focus and dose control or corrections. As such, inferred focus using the disclosed methods may be used in focus control within the scanner and/or inferred dose using the disclosed methods may be used in dose control (illumination control) within the scanner. The inferred focus and/or dose may be used in an optical proximity correction (OPC) control loop.

Although specific reference may have been made above to the use of embodiments of the invention in the context of optical lithography, it will be appreciated that the invention may be used in other applications, for example imprint lithography, and where the context allows, is not limited to optical lithography. In imprint lithography a topography in a patterning device defines the pattern created on a substrate. The topography of the patterning device may be pressed into a layer of resist supplied to the substrate whereupon the resist is cured by applying electromagnetic radiation, heat, pressure or a combination thereof. The patterning device is moved out of the resist leaving a pattern in it after the resist is cured.

Further embodiments are disclosed in the subsequent list of numbered clauses:
1. A method of determining at least one exposure parameter describing an exposure setting of a lithographic exposure process in which a plurality of structures were exposed on a product substrate; the method comprising:
   obtaining production metrology data describing respective product parameter values relating to at least one product parameter of each said plurality of structures;
   grouping said production metrology data into a plurality of neighbor groups, each neighbor group describing a different arrangement of said structures;
   obtaining pre-calibrated sensitivity relationship data for each of said plurality of neighbor groups or
   different combinations thereof, the sensitivity relationship data relating the product parameter, per neighbor group or different combinations thereof, to said at least one exposure parameter; and
   inferring said at least one exposure parameter from the production metrology data and pre-calibrated sensitivity relationship data.
2. A method as defined in clause 1, wherein each said neighbor group describes, for each structure, an arrangement of adjacent structures.
3. A method as defined in clause 2, wherein the grouping step groups a respective product parameter value for each said structure of the plurality of structures into a neighbor group according to the arrangement of adjacent structures of said structure.
4. A method as defined in clause 2 or 3, wherein said arrangement of adjacent structures describes, for each structure, whether each of a plurality of neighborhood regions within a neighborhood area defined around said structure comprises at least one adjacent structure.
5. A method as defined in clause 4, comprising, for each said structure, performing the steps of:
   defining a neighborhood area around said structure;
   dividing the neighborhood area into a plurality of said neighborhood regions;
   determining whether there is at least one adjacent structure in each said neighborhood region; and
   allocating said structure into at least one of said neighbor groups based on the result of said determining whether there is at least one adjacent structure in each said neighborhood region.
6. A method as defined in clause 5, wherein said neighborhood regions number four.
7. A method as defined in clause 5, wherein said neighborhood regions number eight.
8. A method as defined in clause 5, wherein said method further comprises:
   separating said neighborhood regions into an orthogonal set and a diagonal set; and
   performing said determining and allocating steps separately for each of said orthogonal set and diagonal set.
9. A method as defined in clause 8, wherein said step of obtaining pre-calibrated sensitivity relationship data for each of said plurality of neighbor groups or different combinations thereof comprises obtaining pre-calibrated sensitivity relationship data for each of different combinations of an orthogonal group from said orthogonal set and a diagonal group from the diagonal set.
10. A method as defined in any of clauses 4 to 9, wherein the neighborhood area comprises a circular area around said structure; and
   said plurality of said neighborhood regions each comprise segments of said circular area having substantially equal area.
11. A method as defined in any of clauses 4 to 10, wherein said plurality of neighbor groups comprise a neighbor group for each possible combination of said neighborhood regions comprising at least one adjacent structure.
12. A method as defined in any of clauses 3 to 11, wherein an adjacent structure is defined as being within a distance comprising 10 times the exposure wavelength from said structure.
13. A method as defined in any preceding clause, wherein the at least one product parameter comprises one or more of product displacement, critical dimension, any dimensional parameter, any placement parameter, any shape parameter or any roughness parameter of said structures.
14. A method as defined in any preceding clause, wherein said inferring step comprises inferring said at least one exposure parameter from said production metrology data and said pre-calibrated sensitivity relationship data relating to each said neighbor group or combination thereof simultaneously.
15. A method as defined in any preceding clause, wherein said obtaining production metrology data step, said grouping step and said obtaining pre-calibrated sensitivity relationship data step is performed separately for each of a first direction and a second direction of a substrate plane.
16. A method as defined in any of clauses 1 to 13, wherein said obtaining production metrology data step, said grouping step and said obtaining pre-calibrated sensitivity relationship data step is performed separately for each of a first direction and a second direction of a substrate plane and said inferring step comprises inferring said at least one exposure parameter from said production metrology data and said pre-calibrated sensitivity relationship data relating to each said neighbor group and each said direction simultaneously.
17. A method as defined in any preceding clause, wherein each said structure comprises a contact hole.
18. A method as defined in any preceding clause, comprising determining representative production metrology data comprising a representative product parameter value for each said group; and
   wherein said inferring step comprises inferring said at least one exposure parameter from the representative production metrology data and pre-calibrated sensitivity relationship data.
19. A method as defined in clause 18, wherein the representative product parameter value for each said group comprises a mean product parameter value and/or a measure of variance of the product parameter values for each said group.
20. A method as defined in any preceding clause, wherein said at least one exposure parameter comprises one or both of focus and/or dose.
21. A method as defined in any preceding clause, comprising performing said method per exposure field on said substrate to obtain said at least one exposure parameter for each exposure field.
22. A method as defined in any preceding clause, comprising using the at least one exposure parameter to determine a correction for exposure of subsequent product structures.
23. A method as defined in any preceding clause, wherein said structures comprise functional product structures.
24. A method as defined in any of clauses 1 to 22, wherein said structures comprise proxy structures and said production metrology data comprises production proxy metrology data.
25. A method as defined in clause 24 wherein said structures are optimized for exposure parameter sensitivity.
26. A method as defined in clause 24 or 25, wherein said structures comprise or form part of targets comprising said neighbor groups.
27. A method as defined in any of clauses 24 to 26, wherein the method further comprises:
   obtaining mapping data describing a mapping between proxy metrology data and/or first sensitivity relationship data relating to said proxy structures and product metrology data and/or second sensitivity relationship data relating to functional product structures; and
   wherein said inferring step further uses said mapping data to determine said at least one exposure parameter for functional product structures on said product substrate from said proxy metrology data and said pre-calibrated sensitivity relationship data, said pre-calibrated sensitivity relationship data being calibrated for proxy metrology data.
28. A method as defined in any of clauses 1 to 26, comprising performing an initial calibration step to calibrate the pre-calibrated sensitivity relationship data; the initial calibration step comprising:
   obtaining calibration metrology data describing respective calibration product parameter values of a plurality of calibration structures exposed on a calibration substrate for known different values of said at least one exposure parameter;
   grouping said calibration metrology data into said neighbor groups; and
   determining sensitivity relationship data for each said neighbor group or combination thereof, the sensitivity relationship data relating the calibration metrology data, stratified per neighbor group or combination thereof, and said known different values of said at least one exposure parameter.
29. A method as defined in clause 27, comprising performing an initial calibration step to calibrate the pre-calibrated sensitivity relationship data and mapping data; the initial calibration step comprising:
   obtaining calibration proxy metrology data describing respective calibration product parameter values of a plurality of calibration proxy structures exposed on a calibration substrate for known different values of said at least one exposure parameter;
   obtaining calibration product metrology data describing respective calibration product parameter values of a plurality of calibration product structures exposed on the calibration substrate for known different values of said at least one exposure parameter;
   grouping each of said calibration proxy metrology data and said calibration product metrology data into said neighbor groups; and
   for each of said calibration proxy metrology data and said calibration product metrology data: determining sensitivity relationship data for each said neighbor group or combination thereof, the sensitivity relationship data relating the respective calibration metrology data, stratified per neighbor group or combination thereof, and said known different values of said at least one exposure parameter.
30. A method as defined in clause 28 or 29, wherein the plurality of calibration structures are exposed on a calibration substrate for known different values of focus and dose.
31. A method as defined in any of clauses 28 to 30, wherein said initial calibration step is performed separately for each of a first direction and a second direction of a substrate plane.
32. A method as defined in any of clauses 28 to 31, comprising measuring said calibration substrate to obtain said calibration metrology data.
33. A method as defined in any preceding clause, comprising measuring said product substrate to obtain said production metrology data.
34. A method as defined in clause 32 or 33, wherein said measuring step(s) are performed using a scanning electron microscope.
35. A computer program comprising program instructions operable to cause a metrology apparatus to perform the method of any of clauses 1 to 34, when run on a suitable apparatus.
36. A non-transient computer program carrier comprising the computer program of clause 35.
37. A processing arrangement comprising:
   the non-transient computer program carrier of clause 35; and
   a processor operable to run said computer program.
38. A metrology apparatus comprising the processing arrangement of clause 37.
39. A metrology apparatus as defined in clause 38, comprising a scanning electron microscope.
40. A lithographic cell comprising:
   a lithographic apparatus; and
   a metrology apparatus as defined in clause 38 or 39;
   wherein the lithographic apparatus is operable to perform use the determined at least one exposure parameter value in control of a subsequent lithographic exposure.

The terms "radiation" and "beam" used herein encompass all types of electromagnetic radiation, including ultraviolet (UV) radiation (e.g., having a wavelength of or about 365, 355, 248, 193, 157 or 126 nm) and extreme ultra-violet (EUV) radiation (e.g., having a wavelength in the range of 5-20 nm), A well A particle beams, such A ion beams or electron beams.

The term "lens", where the context allows, may refer to any one or combination of various types of components, including refractive, reflective, magnetic, electromagnetic and electrostatic components.

The foregoing description of the specific embodiments will so fully reveal the general nature of the invention that others can, by applying knowledge within the skill of the art, readily modify and/or adapt for various applications such specific embodiments, without undue experimentation, without departing from the general concept of the present invention. Therefore, such adaptations and modifications are intended to be within the meaning and range of equivalents of the disclosed embodiments, based on the teaching and guidance presented herein. It is to be understood that the phraseology or terminology herein is for the purpose of description by example, and not of limitation, such that the terminology or phraseology of the present specification is to be interpreted by the skilled artisan in light of the teachings and guidance.

The breadth and scope of the present invention should not be limited by any of the above-described exemplary embodiments, but should be defined only in accordance with the following claims and their equivalents.

## Claims

1. A method of determining at least one exposure parameter describing an exposure setting of a lithographic exposure process in which a plurality of structures were exposed on a product substrate; the method comprising:
obtaining production metrology data describing respective product parameter values relating to at least one product parameter of each said plurality of structures;
grouping said production metrology data into a plurality of neighbor groups, each neighbor group describing a different arrangement of said structures;
obtaining pre-calibrated sensitivity relationship data for each of said plurality of neighbor groups or different combinations thereof, the sensitivity relationship data relating the product parameter, per neighbor group or different combinations thereof, to said at least one exposure parameter; and
inferring said at least one exposure parameter from the production metrology data and pre-calibrated sensitivity relationship data.

2. A method as claimed in claim 1, wherein each said neighbor group describes, for each structure, an arrangement of adjacent structures.

3. A method as claimed in claim 2, wherein the grouping step groups a respective product parameter value for each said structure of the plurality of structures into a neighbor group according to the arrangement of adjacent structures of said structure.

4. A method as claimed in claim 2 or 3, wherein said arrangement of adjacent structures describes, for each structure, whether each of a plurality of neighborhood regions within a neighborhood area defined around said structure comprises at least one adjacent structure.

5. A method as claimed in claim 4, comprising, for each said structure, performing the steps of:
defining a neighborhood area around said structure;
dividing the neighborhood area into a plurality of said neighborhood regions;
determining whether there is at least one adjacent structure in each said neighborhood region; and
allocating said structure into at least one of said neighbor groups based on the result of said determining whether there is at least one adjacent structure in each said neighborhood region.

6. A method as claimed in claim 5, wherein said method further comprises:
separating said neighborhood regions into an orthogonal set and a diagonal set; and
performing said determining and allocating steps separately for each of said orthogonal set and diagonal set.

7. A method as claimed in any preceding claim, wherein the at least one product parameter comprises one or more of product displacement, critical dimension, any dimensional parameter, any placement parameter, any shape parameter or any roughness parameter of said structures.

8. A method as claimed in any preceding claim, wherein said inferring step comprises inferring said at least one exposure parameter from said production metrology data and said pre-calibrated sensitivity relationship data relating to each said neighbor group or combination thereof simultaneously.

9. A method as claimed in any preceding claim, wherein each said structure comprises a contact hole.

10. A method as claimed in any preceding claim, comprising determining representative production metrology data comprising a representative product parameter value for each said group; and wherein said inferring step comprises inferring said at least one exposure parameter from the representative production metrology data and pre-calibrated sensitivity relationship data.

11. A method as claimed in any preceding claim, wherein said at least one exposure parameter comprises one or both of focus and/or dose.

12. A method as claimed in any preceding claim, comprising using the at least one exposure parameter to determine a correction for exposure of subsequent product structures.

13. A method as claimed in any preceding claim, wherein said structures comprise functional product structures.

14. A computer program comprising program instructions operable to cause a metrology apparatus to perform the method of any of claims 1 to 13, when run on a suitable apparatus.
a processor operable to run said computer program.

15. A metrology apparatus comprising the computer program of claim 14.
